# EUROPEAN PATENT APPLICATION

(11) **EP 4 722 825 A1**
(43) Date of publication of application: **08.04.2026**
(21) Application number: 24843248.6
(22) Date of filing: 26.04.2024
(51) Int. Cl.: G04G 17/06, G04G 17/04, G04G 17/08, G04G 21/04, G06F 1/16, H05K 1/14

(54) **WEARABLE ELECTRONIC DEVICE COMPRISING CONDUCTIVE CONNECTION MEMBER AND ANTENNA**

(30) Priority: 20.07.2023 KR 20230094603; 25.07.2023 KR 20230096828
(71) Applicant: Samsung Electronics Co., Ltd., Suwon-si, Gyeonggi-do 16677 (KR)
(72) Inventor: KIM, Hyungkeun, Suwon-si, Gyeonggi-do 16677 (KR); SON, Jongkuck, Suwon-si, Gyeonggi-do 16677 (KR)
(74) Representative: Appleyard Lees IP LLP
(86) International application number: PCT/KR2024/005721
(87) International publication number: WO 2025/018525

(57) **Abstract**

A wearable electronic device according to various embodiments of the present invention comprises: a housing including a conductive material; a support member disposed inside the housing; a display disposed on the support member; a printed circuit board disposed on the support member; and a conductive connection member (320) including a first portion that can be coupled to at least a portion of the housing and a second portion electrically connected to the ground of the printed circuit board. Therefore, the wearable electronic device can support various frequency bands and improve antenna performance.

## Description

### [Technical Field]

Various embodiments of the disclosure disclose a wearable electronic device including a conductive connection member and an antenna.

### [Background Art]

The use of electronic devices such as bar-type, foldable-type, rollable-type, or sliding-type smartphones or tablet personal computers (tablet PCs) is increasing.

The electronic devices are being developed into wearable forms that are wearable by users in order to improve portability and accessibility.

The wearable-type electronic devices may include smart rings or watches configured to be worn on users' fingers, wrists, and/or ankles.

### [Disclosure of Invention]

### [Technical Problem]

A wearable electronic device (e.g., a watch) may transmit and receive various data with another electronic device (e.g., a smartphone) using wireless communication.

The wearable electronic device may include at least one antenna to perform wireless communication with another electronic device.

For example, the wearable electronic device may perform wireless communication with another electronic device by using a conductive housing as a loop antenna.

The wearable electronic device may have limitations in providing various frequency bands due to the size of the housing and spatial constraints for arranging other components.

Various embodiments of the disclosure may provide a wearable electronic device capable of supporting various frequency bands by utilizing a conductive connection member (e.g., an FPCB) arranged to be coupled with a housing (e.g., an antenna radiator) as a ground.

The technical problems to be addressed by this disclosure are not limited to those described above, and other technical problems not mentioned above may be clearly understood by a person ordinarily skilled in the related art to which the disclosure pertains.

### [Solution to Problem]

A wearable electronic device according to an embodiment of the disclosure may include a housing including a conductive material, a support member disposed inside the housing, a display disposed on the support member, a printed circuit board disposed on the support member, and a conductive connection member including a first portion arranged to be coupled to at least a portion of the housing and a second portion electrically connected to a ground of the printed circuit board.

### [Advantageous Effects of Invention]

According to various embodiments of the disclosure, various frequency bands may be supported and antenna performance may be improved by utilizing a conductive connection member (e.g., a Hall IC FPCB) coupled in a coupling structure with a housing (e.g., an antenna radiator) as a ground.

According to various embodiments of the disclosure, antenna performance in a specific frequency band (e.g., a GPS (Global Positioning System) frequency band such as about 1100 MHz to 1600 MHz) may be improved by arranging the housing (e.g., an antenna radiator) and the conductive connection member in a coupling structure and expanding a ground area through the conductive connection member.

In addition, various effects that are directly or indirectly identified through this document may be provided.

### [Brief Description of Drawings]

In connection with the description of the drawings, the same or similar components may be denoted by the same or similar reference numerals.
FIG. 1 is a block diagram of an electronic device in a network environment, according to various embodiments of the disclosure.
FIG. 2A is a perspective view schematically illustrating a front side of a wearable electronic device according to an embodiment of the disclosure.
FIG. 2B is a perspective view schematically illustrating a rear side of the wearable electronic device of FIG. 2A according to an embodiment of the disclosure.
FIG. 3 is an exploded perspective view schematically illustrating the wearable electronic device according to an embodiment of the disclosure illustrated in FIG. 2A.
FIG. 4 is a perspective view schematically illustrating a portion of a configuration of a wearable electronic device according to an embodiment of the disclosure.
FIG. 5 is a view schematically illustrating a cross section of the wearable electronic device according to an embodiment of the disclosure taken along line 5-5' in FIG. 4.
FIG. 6 is a diagram schematically illustrating a configuration of an embodiment of a conductive connection member of a wearable electronic device according to an embodiment of the disclosure.
FIG. 7 is a view schematically illustrating a configuration of various embodiments of a conductive connection member of a wearable electronic device according to an embodiment of the disclosure.
FIG. 8 is a view schematically illustrating a configuration in which a conductive connection member of a wearable electronic device according to an embodiment of the disclosure includes an expanded area.
FIG. 9 is a view comparing radiation efficiency and frequency resonance variation of an antenna of a wearable electronic device according to an embodiment of the disclosure with those of other embodiments.
FIG. 10 is a view schematically illustrating a configuration in which a printed circuit board of a wearable electronic device according to an embodiment of the disclosure includes a matching circuit.
FIG. 11 is a view schematically illustrating a configuration of a matching circuit of a wearable electronic device according to an embodiment of the disclosure.
FIG. 12 is a view schematically illustrating a passive resonance shift of an antenna by using a matching circuit of a wearable electronic device according to an embodiment of the disclosure.

### [Mode for the Invention]

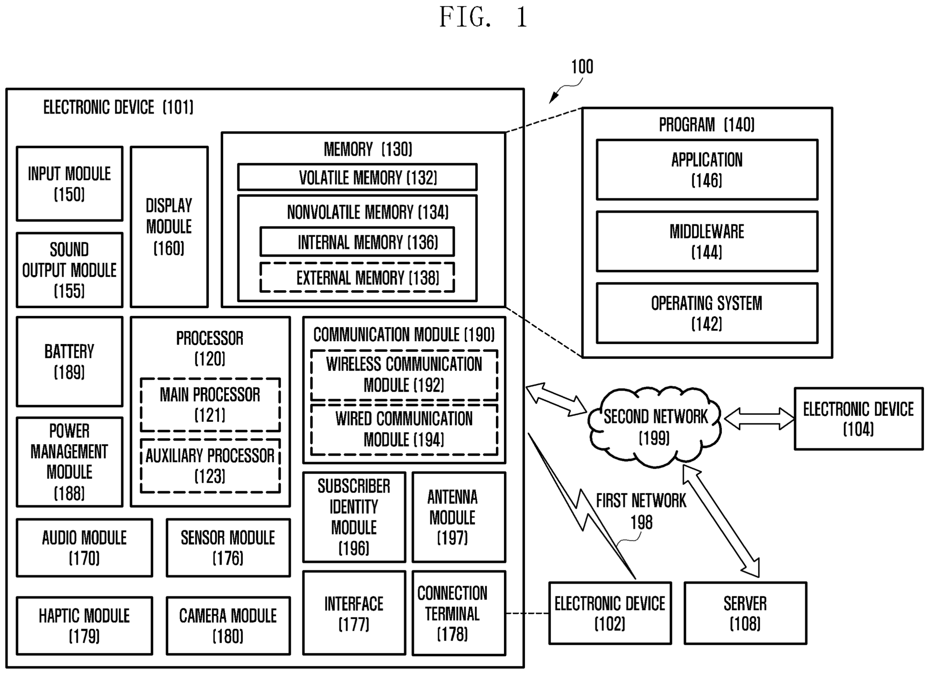

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

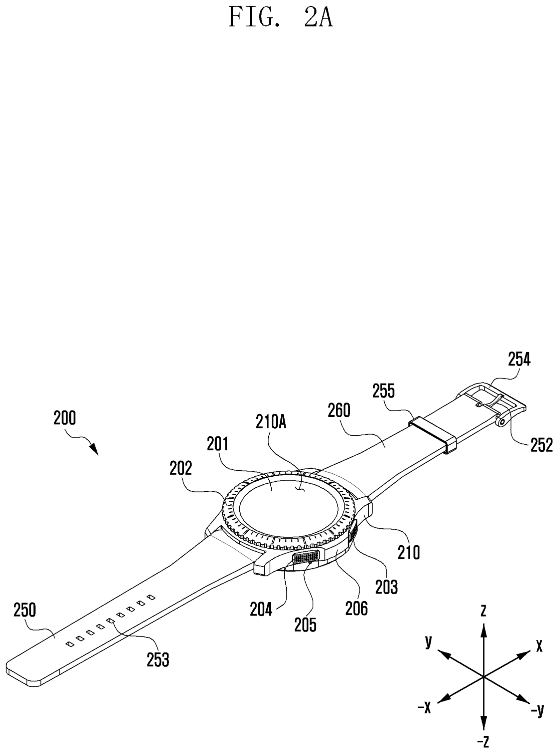

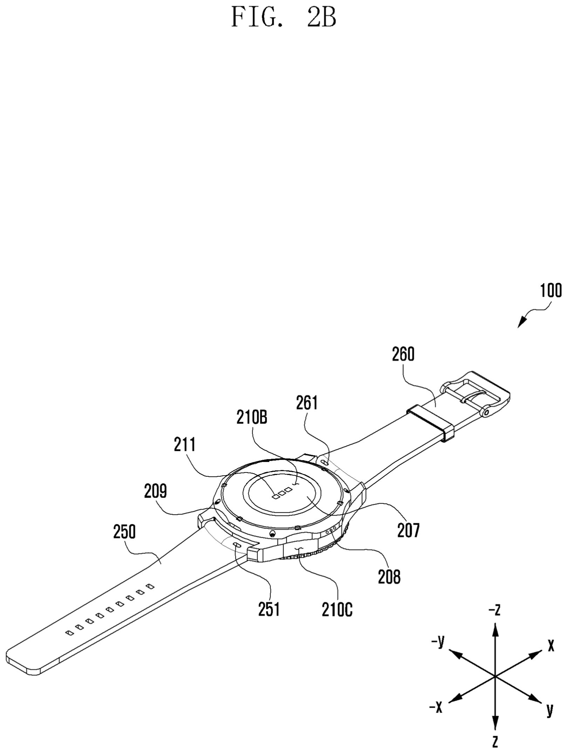

FIG. 2A is a perspective view schematically illustrating a front side of a wearable electronic device according to an embodiment of the disclosure. FIG. 2B is a perspective view illustrating a rear side of the wearable electronic device of FIG. 2A according to an embodiment of the disclosure.

Referring to FIGS. 2A and 2B, a wearable electronic device 200 (e.g., the electronic device 101 of FIG. 1) according to an embodiment may include a housing 210 including a first surface (or a front surface) 210A oriented in a first direction (e.g., the z-axis direction), a second surface (or a rear surface) 210B oriented in a second direction (e.g., the -z-axis direction) opposite to the first direction, and a side surface 210C surrounding a space between the first surface 210A and the second surface 210B, and binding members 250 and 260 connected to at least a portion of the housing 210 and configured to detachably fasten the wearable electronic device 200 to a part of a user's body (e.g., a wrist or an ankle).

In an embodiment (not illustrated), the housing 210 may refer to a structure forming a portion of the first surface 210A, the second surface 210B, and the side surface 210C of FIG. 2A. According to an embodiment, at least a portion of the first surface 210A may be defined by a substantially transparent front surface plate 201 (e.g., a glass plate or a polymer plate with various coating layers). The second surface 210B may be provided by a substantially opaque rear surface plate 207. The rear surface plate 207 may be made of, for example, coated or colored glass, ceramic, polymer, metal (e.g., aluminum, stainless steel (STS), or magnesium), or a combination of two or more of these materials. The side surface 210C may be defined by a side surface bezel structure (or side surface structure) 206 coupled to the front surface plate 201 and the rear surface plate 207 and including metal and/or polymer. In some embodiments, the rear surface plate 207 and the side surface bezel structure 206 may be integrally configured and may include the same material (e.g., a metal material such as aluminum). The binding members 250 and 260 may be formed of various materials and in various shapes. Multiple integrated unit links may be disposed to be movable with respect to each other by using a woven material, leather, rubber, urethane, metal, ceramic, or a combination of two or more of these materials.

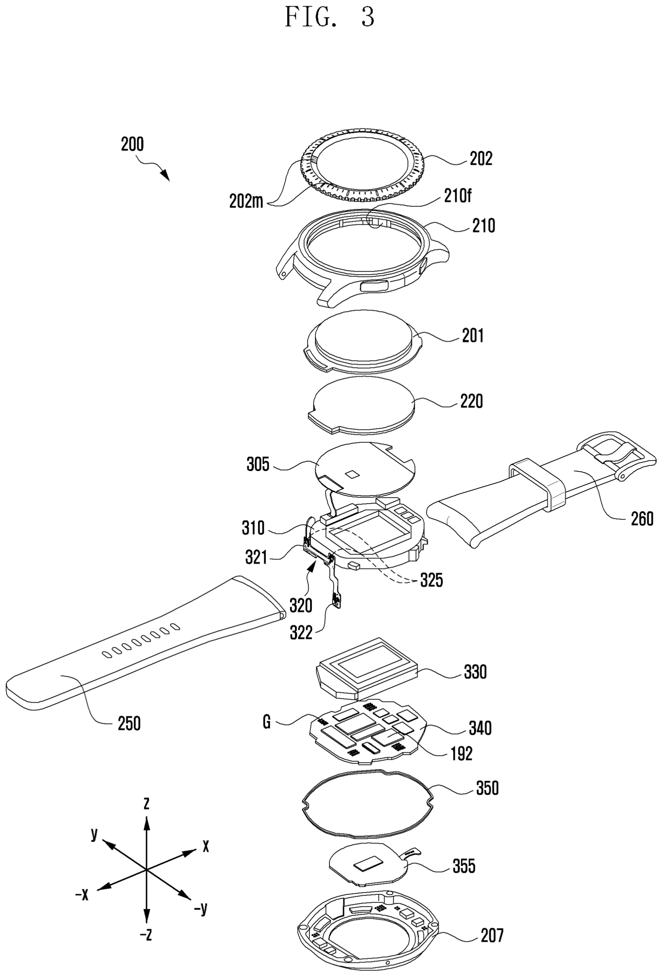

According to an embodiment, the wearable electronic device 200 may include at least one of a display 220 (the display 220 of FIG. 3), audio modules 205 and 208, a sensor module 211, key input devices 202, 203, and 204, and a connector hole 209. In various embodiments, in the wearable electronic device 200, at least one of the above-described components (e.g., the key input devices 202, 203, and 204, the connector hole 209, or the sensor module 211) may be omitted or other components may be additionally included.

According to an embodiment, the display 220 (e.g., the display 220 of FIG. 3) may be exposed through, for example, a substantial portion of the front surface plate 201. The shape of the display 220 may correspond to the shape of the front surface plate 201 and may be various shapes such as circular, elliptical, or polygonal. The display 220 may be coupled to or disposed adjacent to a touch detection circuit, a pressure sensor capable of measuring touch intensity (pressure), and/or a fingerprint sensor.

According to an embodiment, the audio modules 205 and 208 may include a microphone hole 205 and a speaker hole 208. The microphone hole 205 may include a microphone disposed therein to acquire external sound, and in some embodiments, multiple microphones may be disposed therein to detect the direction of sound. The speaker hole 208 may be used for an external speaker and a call receiver. According to various embodiments, the speaker hole 208 and the microphone hole 205 may be implemented as a single hole, or a speaker (e.g., a piezo speaker) may be included without the speaker hole 208.

According to an embodiment, the sensor module 211 may generate an electrical signal or data values corresponding to an operating state inside the wearable electronic device 200 or an environmental state outside the electronic device 200. The sensor module 211 may include, for example, a biometric sensor module 211 (e.g., an HRM sensor) disposed on the second surface 210B of the housing 210. The wearable electronic device 200 may further include at least one additional sensor module (not illustrated), for example, a gesture sensor, an inertial sensor, a gyro sensor, an atmospheric pressure sensor, a magnetic sensor, an acceleration sensor, a grip sensor, a color sensor, an infrared ray (IR) sensor, a biometric sensor, a temperature sensor, a humidity sensor, or a light sensor. In an embodiment, the sensor module 211 may further include at least one Hall sensor (e.g., a Hall IC) (e.g., the Hall sensor 325 of FIG. 3).

According to an embodiment, the key input devices 202, 203, and 204 may include a wheel key 202 disposed on the first surface 210A of the housing 210 and rotatable in at least one direction, and/or side key buttons 203 and 204 disposed on the side surface 210C of the housing 210. The wheel key 202 may have a shape corresponding to the shape of the front surface plate 201. In an embodiment, the wearable electronic device 200 may not include some or all of the above-mentioned key input devices 202, 203, and 204, and the excluded key input devices 202, 203, and 204 may be implemented in another form, such as soft keys, on the display 220. According to an embodiment, the connector hole 209 may accommodate a connector (e.g., a USB connector) configured to transmit and receive power and/or data with an external electronic device (e.g., the external electronic devices 102, 104, and 108 of FIG. 1), and may include another connector hole (not illustrated) configured to accommodate a connector for transmitting and receiving audio signals with an external electronic device. The wearable electronic device 200 may further include, for example, a connector cover (not illustrated), which covers at least a portion of the connector hole 209 and blocks external foreign matter from entering the connector hole.

According to an embodiment, the binding members 250 and 260 may be detachably coupled to at least a portion of the housing 210 by using locking members 251 and 261. Each of the binding members 250 and 260 may include at least one of a fixing member 252, fixing member fastening holes 253, a band guide member 254, and a band fixing ring 255.

According to an embodiment, the fixing member 252 may be configured to fix the housing 210 and the binding members 250 and 260 to a part of a user's body (e.g., a wrist or an ankle). The fixing member fastening holes 253 allow the housing 210 and the binding members 250 and 260 to be fixed to a portion of the user's body in cooperation with the fixing member 252. The band guide member 254 is configured to limit the movement range of the fixing member 252 when the fixing member 252 is fastened to any of the fixing member fastening holes 253, thereby ensuring that the binding members 250 and 260 are brought into close contact with and bound to a portion of the user's body. The band fixing ring 255 may limit the movement range of the binding members 250 and 260 in the state in which the fixing member 252 and the fixing member fastening holes 253 are fastened to each other.

FIG. 3 is an exploded perspective view schematically illustrating the wearable electronic device according to an embodiment of the disclosure illustrated in FIG. 2A.

Referring to FIG. 3, the wearable electronic device 200 may include a housing 210 (e.g., a side surface bezel structure), a wheel key 202, a front surface plate 201, a display 220, a first antenna 305, a second antenna 355, a support member 310 (e.g., a bracket), a conductive connection member 320, a battery 330, a printed circuit board 340, a sealing member 350, a rear surface plate 207, and/or binding members 250 and 260.

According to an embodiment, the wearable electronic device 200 illustrated in FIG. 3 may include the electronic device 101 illustrated in FIG. 1A or the embodiments illustrated in FIGS. 2A and 2B. In the following description of the wearable electronic device 200, components that are substantially identical to those illustrated in FIGS. 1, 2A, and 2B are denoted by the same reference numerals, and redundant descriptions of their functions may be omitted.

According to an embodiment, the wheel key 202 may include at least one magnet 202m. For example, the wheel key 202 may include a plurality of magnets 202m arranged at regular intervals.

According to an embodiment, at least a portion of the housing 210 may function as an antenna radiator of the wearable electronic device 200. For example, the housing 210 may include a conductive material. For example, the housing 210 may include a metallic material and/or a non-metallic material (e.g., a polymer). A point 210f of the housing 210 may be electrically connected to a wireless communication module 192 disposed on the printed circuit board 340 through a feeding path. For example, the point 210f of the housing 210 may be electrically connected to the feeding path and the wireless communication module 192 through a contact pad, a C-clip, or a conductive foam spring. For example, the housing 210 may operate as an antenna supporting frequency bands of third generation (3G), long term evolution (LTE), and/or global positioning system (GPS).

According to an embodiment, the housing 210 may be spaced apart from the support member 310 (e.g., a bracket). For example, an inner surface of the housing 210 may be spaced apart from an outer surface of the support member 310. According to various embodiments, the support member 310 may be disposed inside the housing 210, may be at least partially connected to the housing 210, or may be integrally formed with the housing 210. The support member 310 may be made of, for example, a metallic material and/or a non-metallic (e.g., polymer) material. For example, the support member 310 may have a display 220 (e.g., the display module 160 of FIG. 1A) coupled to the first surface (e.g., the surface oriented in the z-axis direction) and the printed circuit board 340 coupled to the second surface (e.g., the other surface oriented in the -z-axis direction).

According to an embodiment, the conductive connection member 320 may be disposed on at least a portion of an outer surface (e.g., an external surface) of the support member 310. For example, the conductive connection member 320 may be disposed between the housing 210 and the support member 310. The conductive connection member 320 may be spaced apart from the housing 210. The conductive connection member 320 may be coupled to the housing 210. The conductive connection member 320 may be coupled to the housing 210 in a coupling structure. For example, a distance between the conductive connection member 320 and the housing 210 may range from about 0.3 mm to about 1.2 mm. The conductive connection member 320 may be electrically connected to a ground G formed on the printed circuit board 340 through a grounding path. For example, a second portion 322 of the conductive connection member 320 may be electrically connected to the ground G of the printed circuit board 340 through the grounding path. As the conductive connection member 320 is electrically connected to the ground G of the printed circuit board 340, a ground area of the antenna including at least a portion of the housing 210 may be expanded.

According to an embodiment, a first portion 321 of the conductive connection member 320 may be disposed on the outer surface (e.g., an external surface) of the support member 310, and a second portion 322 may be electrically connected to the printed circuit board 340. For example, the first portion 321 of the conductive connection member 320 may be coupled to the housing 210. The second portion 322 of the conductive connection member 320 may be electrically connected to the ground G of the printed circuit board 340. In an embodiment, the conductive connection member 320 may include a flexible printed circuit board (FPCB). For example, the conductive connection member 320 may include a Hall IC FPCB. The conductive connection member 320 may include a Hall sensor 325. For example, the conductive connection member 320 may include at least one Hall sensor 325 in the first portion 321. The at least one Hall sensor 325 may be disposed at a predetermined position of the first portion 321 of the conductive connection member 320. The Hall sensor 325 may detect at least one of a rotation direction (e.g., movement) and a rotation position (e.g., a displacement position) of the wheel key 202. For example, the Hall sensor 325 may detect a rotation angle of the wheel key 202 by using a change in magnetic force of the magnet 202m sensed during the rotation of the wheel key 202.

According to an embodiment, a processor (e.g., the processor 120 of FIG. 1A), memory (e.g., the memory 130 of FIG. 1A), a sensor module (e.g., the sensor module 176 of FIG. 1A and/or the sensor module 211 of FIG. 2B), a wireless communication module 192, and/or an interface (e.g., the interface 177 of FIG. 1A) may be disposed on the printed circuit board 340.

According to an embodiment, the processor 120 may include, for example, one or more of a central processing unit, an application processor, a graphics processing unit (GPU), an application processor sensor processor, or a communication processor.

According to an embodiment, the memory 130 may include volatile memory or non-volatile memory.

According to an embodiment, the sensor module (e.g., the sensor module 176 of FIG. 1A and/or the sensor module 211 of FIG. 2B) may include at least one of an infrared ray (IR) sensor, a light sensor, a proximity sensor, a touch sensor, an inertial sensor, a gyro sensor, an acceleration sensor, and/or a pressure sensor.

According to an embodiment, the wireless communication module 192 may include a radio frequency IC (RFIC). The wireless communication module 192 may deliver a feeding signal to a point 210f of the housing 210 that is electrically connected through a feeding path.

According to an embodiment, the interface 177 may include, for example, a high-definition multimedia interface (HDMI), a universal serial bus (USB) interface, an SD card interface, and/or an audio interface. The interface 177 may, for example, electrically or physically connect the wearable electronic device 200 to an external electronic device (e.g., the external electronic devices 102, 104, and 108 of FIG. 1) and may include a USB connector, an SD card/MMC connector, or an audio connector.

According to an embodiment, the battery 330 may serve as a device that supplies power to at least one component of the wearable electronic device 200, and may include, for example, a non-rechargeable primary battery, a rechargeable secondary battery, or a fuel cell. At least a portion of the battery 330 may be, for example, disposed on substantially the same plane as the printed circuit board 340. The battery 330 may be integrally disposed inside the wearable electronic device 200, or may be disposed to be detachable from the wearable electronic device 200.

According to an embodiment, the first antenna 305 may be disposed between the display 220 (e.g., the display module 160 of FIG. 1A) and the support member 310. The first antenna 305 may include, for example, a near-field communication (NFC) antenna, a wireless charging antenna, and/or a magnetic secure transmission (MST) antenna. The first antenna 305 may, for example, perform near-field communication with an external electronic device (e.g., the external electronic devices 102, 104, and 108 of FIG. 1), transmit or receive power required for charging wirelessly, and transmit a magnetic-based signal including a near-field communication signal or payment data. In an embodiment, an antenna structure may be formed by at least a portion or a combination of the housing 210 and/or the support member 310.

According to an embodiment, the second antenna 355 may be disposed between the printed circuit board 340 and the rear surface plate 207. The second antenna 355 may include, for example, a near-field communication (NFC) antenna, a wireless charging antenna, and/or a magnetic secure transmission (MST) antenna. The second antenna 355 may, for example, perform near-field communication with an external electronic device (e.g., the external electronic devices 102, 104, and 108 of FIG. 1), transmit or receive power required for charging wirelessly, and transmit a magnetic-based signal including a near-field communication signal or payment data. In an embodiment, an antenna structure may be formed by at least a portion or a combination of the housing 210 and/or the rear surface plate 207.

According to an embodiment, the sealing member 350 may be positioned between the housing 210 and the rear surface plate 207. The sealing member 350 may be configured to block moisture and/or foreign substances from entering a space surrounded by the housing 210 and the rear surface plate 207 from the outside.

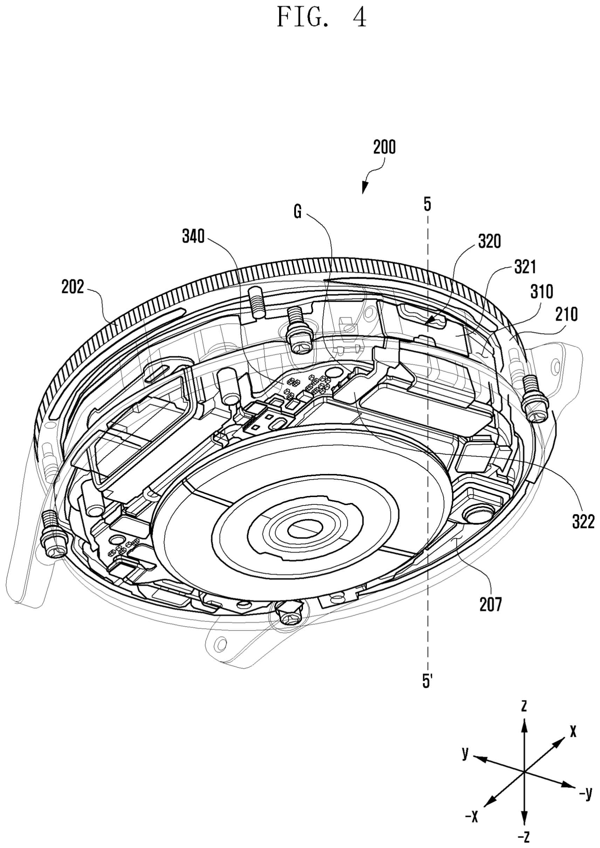

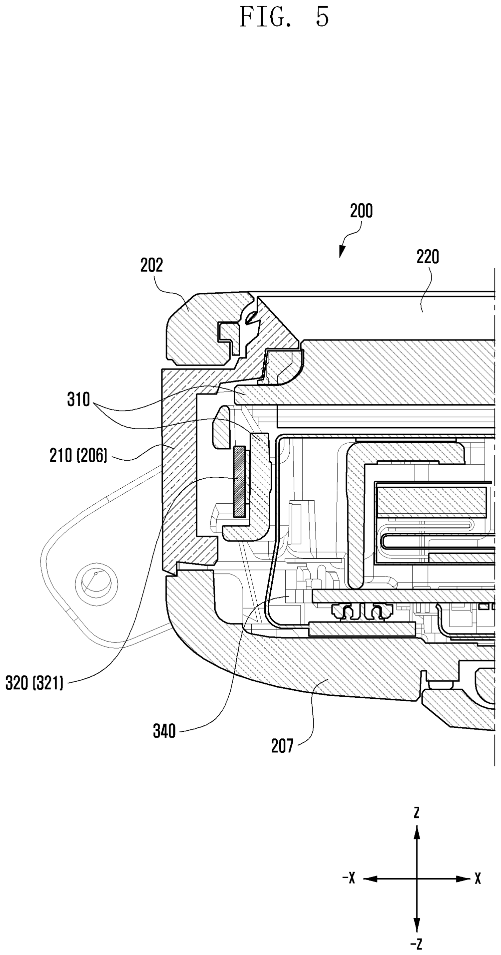

FIG. 4 is a perspective view schematically illustrating a portion of a configuration of a wearable electronic device according to an embodiment of the disclosure. FIG. 5 is a view schematically illustrating a cross section of the wearable electronic device according to an embodiment of the disclosure taken along line 5-5' in FIG. 4 .

Referring to FIGS. 4 and 5, the housing 210 of the wearable electronic device 200 according to an embodiment of the disclosure may be disposed at least partially on the second direction (e.g., the -z-axis direction (on the rear surface)) of the wheel key 202, and may form an exterior appearance of the wearable electronic device 200.

According to an embodiment, the housing 210 may include a conductive material, and at least a portion (e.g., the side surface bezel structure 206 of FIG. 2) of the housing 210 may function as an antenna radiator of the wearable electronic device 200. For example, at least a portion of the housing 210 may operate as a radiator of an antenna supporting frequency bands of third generation (3G), long term evolution (LTE), and/or global positioning system (GPS).

According to an embodiment, a support member 310 may be disposed inside the housing 210. For example, an inner surface of the housing 210 may be spaced apart from at least a portion of an outer surface of the support member 310. For example, a display 220 may be disposed in the first direction (e.g., the z-axis direction (on the first surface)) of the support member 310, and a printed circuit board 340 may be disposed in the second direction (e.g., the -z-axis direction (on the second surface)) of the support member 310.

According to an embodiment, the conductive connection member 320 (e.g., an FPCB or a Hall IC FPCB) may be disposed on at least a portion of the outer surface of the support member 310. The conductive connection member 320 may be disposed between the housing 210 and the support member 310. The conductive connection member 320 may be coupled to the housing 210. The conductive connection member 320 may be coupled to the housing 210 in a coupling structure. For example, a spacing distance between the conductive connection member 320 and the housing 210 may range from about 0.3 mm to about 1.2 mm.

According to an embodiment, the first portion 321 of the conductive connection member 320 may be disposed on the external surface of the support member 310, and the second portion 322 may be electrically connected to the ground G of the printed circuit board 340. As the conductive connection member 320 is electrically connected to the ground G of the printed circuit board 340, a ground area of the antenna including at least a portion of the housing 210 may be expanded.

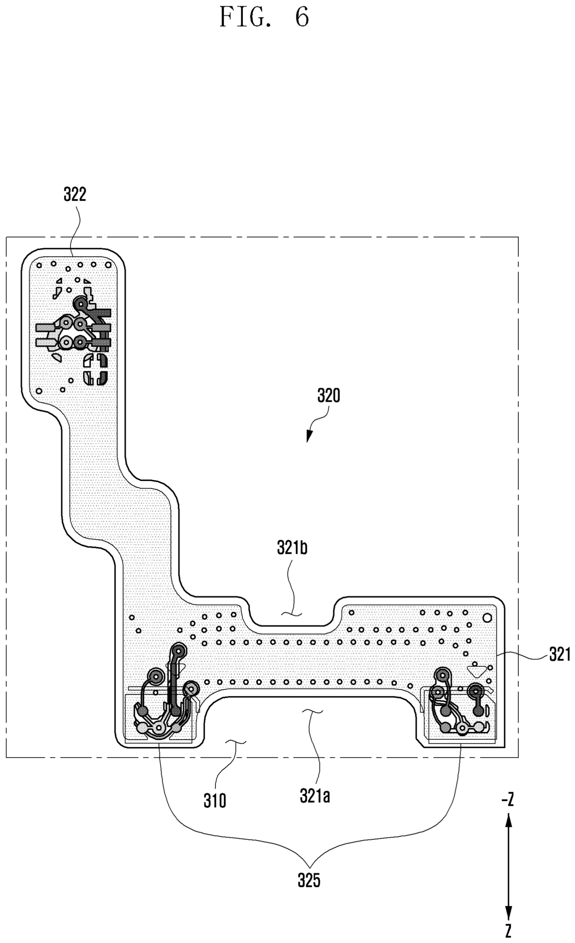

FIG. 6 is a diagram schematically illustrating a configuration of an embodiment of a conductive connection member of a wearable electronic device according to an embodiment of the disclosure.

Referring to FIG. 6, a conductive connection member 320 according to an embodiment may include a first portion 321 and a second portion 322 integrally extending from the first portion 321.

According to an embodiment, the first portion 321 of the conductive connection member 320 may be disposed on at least a portion of an external surface of a support member 310 (e.g., a bracket). For example, the first portion 321 may be coupled to at least a portion of the external surface of the support member 310. The second portion 322 of the conductive connection member 320 may have a predetermined length from the first portion 321 and may be electrically connected to a ground G of a printed circuit board 340. The first portion 321 of the conductive connection member 320 may include a Hall sensor 325. For example, the conductive connection member 320 may include at least one Hall sensor 325 in the first portion 321. The at least one Hall sensor 325 may be disposed at a predetermined position of the first portion 321 of the conductive connection member 320.

According to an embodiment, the first portion 321 of the conductive connection member 320 may include a first groove 321a and/or a second groove 321b. For example, the first groove 321a and/or the second groove 321b may reduce assembly tolerance during assembly of a wearable electronic device 200. For example, the first groove 321a and/or the second groove 321b may be arranged at predetermined positions when assembled on an external surface of the support member 310. For example, the first groove 321a may be formed in a first direction (e.g., the z-axis direction) of the conductive connection member 320, and the second groove 321b may be formed in the second direction (e.g., the -z-axis direction) of the conductive connection member 320. For example, the first groove 321a may be formed to have a larger size than the second groove 321b. In an embodiment, the first groove 321a and/or the second groove 321b may be omitted.

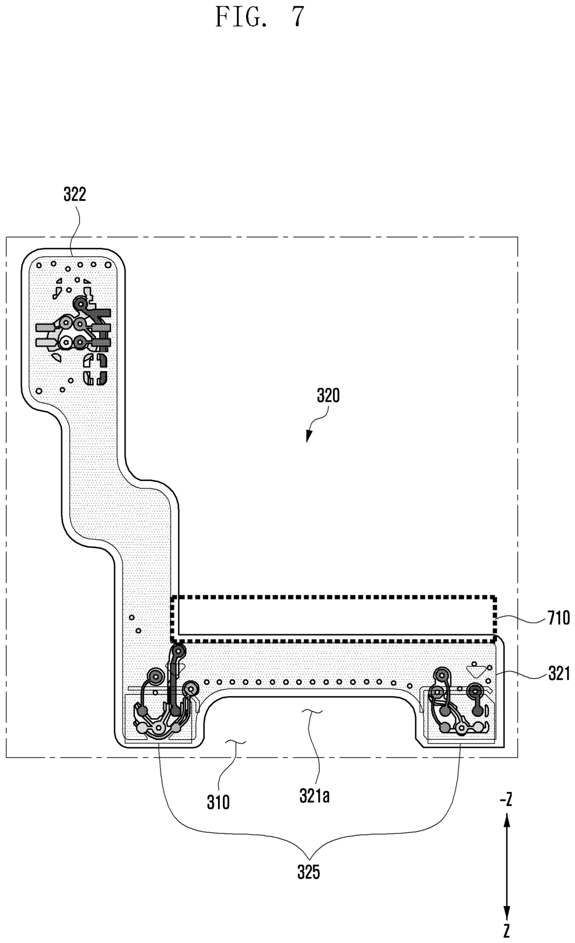

FIG. 7 is a view schematically illustrating a configuration of various embodiments of a conductive connection member of a wearable electronic device according to an embodiment of the disclosure.

Referring to FIG. 7, a conductive connection member 320 according to an embodiment may include a first portion 321 and a second portion 322 integrally extending from the first portion 321.

According to an embodiment, the first portion 321 of the conductive connection member 320 may be disposed on at least a portion of an external surface of a support member 310 (e.g., a bracket). The second portion 322 of the conductive connection member 320 may have a predetermined length from the first portion 321 and may be electrically connected to a ground G of a printed circuit board 340.

According to various embodiments, the first portion 321 of the conductive connection member 320 may include a first groove 321a. For example, the first groove 321a may reduce assembly tolerance during assembly of a wearable electronic device 200. For example, the first groove 321a may be arranged at a predetermined position when assembled on an external surface of the support member 310. In an embodiment, the first groove 321a may be omitted.

According to an embodiment, the conductive connection member 320 illustrated in FIG. 7 may have a configuration in which the second groove 321b is omitted, compared with the conductive connection member 320 of FIG. 6. For example, the conductive connection member 320 of FIG. 7 may have the periphery of the second groove 321b removed by a first area 710 (e.g., a reduced area), compared with the conductive connection member 320 of FIG. 6. For example, the first area 710 (e.g., the reduced area) from which the periphery of the second groove 321b is removed in FIG. 7 may correspond to a portion of the support member 310.

According to various embodiments, as illustrated in FIG. 7, when the conductive connection member 320 has a portion removed by the first area 710 (e.g., the reduced area), a ground area coupled with a housing 210 (e.g., an antenna radiator) may be reduced. In this case, an extent to which the conductive connection member 320 is coupled with the housing 210 may be decreased.

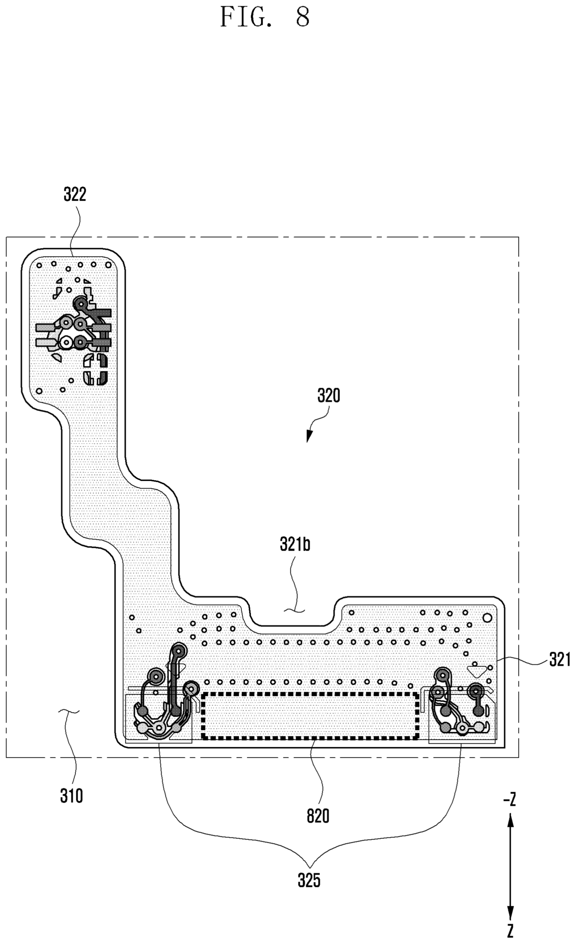

FIG. 8 is a view schematically illustrating a configuration in which a conductive connection member of a wearable electronic device according to an embodiment of the disclosure includes an expanded area.

Referring to FIG. 8, the conductive connection member 320 according to various embodiments may include a first portion 321 and a second portion 322 integrally extending from the first portion 321.

According to an embodiment, the first portion 321 of the conductive connection member 320 may be disposed on at least a portion of an external surface of a support member 310 (e.g., a bracket). The second portion 322 of the conductive connection member 320 may have a predetermined length from the first portion 321 and may be electrically connected to a ground G of a printed circuit board 340.

According to various embodiments, the first portion 321 of the conductive connection member 320 may include a second groove 321b. For example, the second groove 321b may reduce assembly tolerance during assembly of a wearable electronic device 200. For example, the second groove 321b may be arranged at a predetermined position when assembled on an external surface of the support member 310. For example, the second groove 321b may be omitted.

According to an embodiment, the conductive connection member 320 illustrated in FIG. 8 may have a configuration in which the first groove 321a is omitted, compared with the conductive connection member 320 of FIG. 6. For example, the conductive connection member 320 of FIG. 8 may include a second area 820 (e.g., an expanded area) compared with the conductive connection member 320 of FIG. 6. For example, the second area 820 (e.g., the expanded area) illustrated in FIG. 8 may be disposed on a portion of the support member 310. For example, the second area 820 may include a conductive member (e.g., a conductive material).

According to various embodiments, as illustrated in FIG. 8, when the conductive connection member 320 includes the second area 820 (e.g., the expanded area), a ground area coupled with a housing 210 (e.g., an antenna radiator) may be expanded. In this case, an extent to which the conductive connection member 320 is coupled with the housing 210 may be increased.

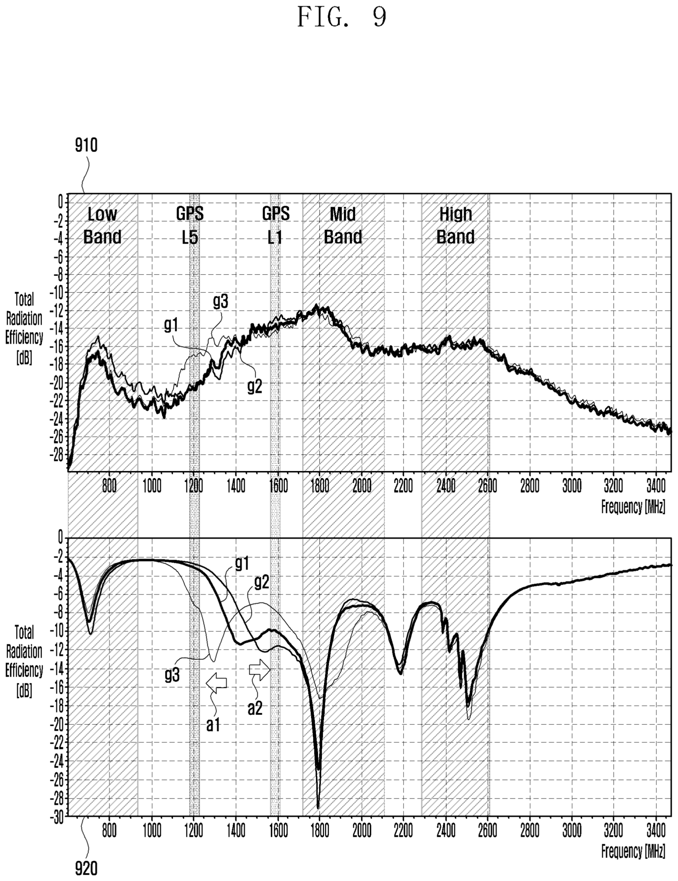

FIG. 9 is a view comparing radiation efficiency and frequency resonance variation of an antenna of a wearable electronic device according to an embodiment of the disclosure with those of other embodiments.

For example, an upper diagram 910 of FIG. 9 may be a graph comparing radiation efficiency of an antenna of a wearable electronic device 200 according to an embodiment of the disclosure with those of other embodiments. For example, a lower diagram 920 of FIG. 9 may be a graph comparing frequency resonance variation of an antenna of a wearable electronic device 200 according to an embodiment of the disclosure with those of other embodiments.

According to an embodiment, in the upper diagram 910 of FIG. 9, a first graph g1 may represent radiation efficiency in a case where a conductive connection member 320 is coupled with a housing 210 (e.g., an antenna radiator) as illustrated in FIG. 6. For example, a second graph g2 may represent radiation efficiency in a case where a conductive connection member 320, from which a first area 710 (e.g., a reduced area) is removed, is coupled with a housing 210 (e.g., an antenna radiator) as illustrated in FIG. 7. For example, a third graph g3 may represent radiation efficiency in a case where a conductive connection member 320 having a second area 820 (e.g., an expanded area) that includes a conductive material is coupled with a housing 210 (e.g., an antenna radiator) as illustrated in FIG. 8.

Referring to the upper diagram 910 of FIG. 9, it may be observed that the third graph g3, which represents a case where a conductive connection member 320 having a second area 820 (e.g., an expanded area) that includes a conductive material is coupled with a housing 210 (e.g., an antenna radiator), shows improved radiation efficiency in a frequency band ranging from about 1140 MHz to about 1400 MHz compared with the first graph g1 and the second graph g2. According to an embodiment, a wearable electronic device 200 including the conductive connection member 320 according to an embodiment of the disclosure may additionally support a frequency band ranging from GPS L5 (e.g., about 1140 MHz) to GPS L1 (e.g., about 1580 MHz).

According to various embodiments, in the lower diagram 920 of FIG. 9, the first graph g1 may represent antenna resonance in a case where the conductive connection member 320 illustrated in FIG. 6 is coupled with the housing 210 (e.g., an antenna radiator). For example, the second graph g2 may represent antenna resonance in a case where the conductive connection member 320, from which the first area 710 (e.g., a reduced area) is removed as illustrated in FIG. 7, is coupled with the housing 210 (e.g., an antenna radiator). For example, the third graph g3 may represent antenna resonance in a case where the conductive connection member 320 having the second area 820 (e.g., an expanded area) that includes a conductive material is coupled with the housing 210 (e.g., an antenna radiator) as illustrated in FIG. 8.

Referring to the lower diagram 920 of FIG. 9, it may be observed that the third graph g3, which represents a case where the conductive connection member 320 having the second area 820 (e.g., an expanded area) that includes a conductive material is coupled with the housing 210 (e.g., an antenna radiator), exhibits antenna resonance shifts (e.g., first arrow a1 and second arrow a2) that occur more easily compared with the first graph g1 and the second graph g2. For example, as illustrated in FIG. 8, when the conductive connection member 320 having the second area 820 (e.g., an expanded area) that includes a conductive material is coupled with the housing 210 (e.g., an antenna radiator), it may be observed that a shift to a lower-frequency band easily occurs, as indicated by the first arrow a1.

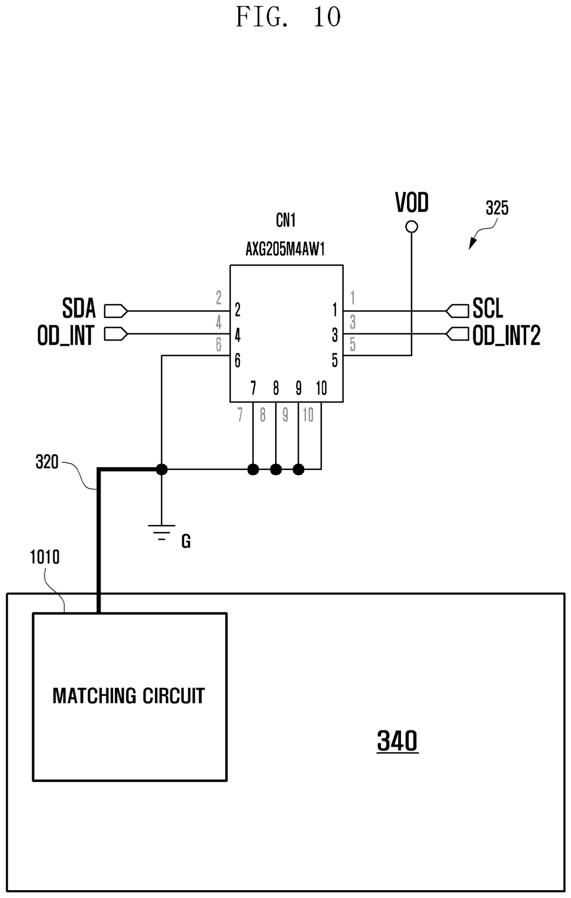

FIG. 10 is a view schematically illustrating a configuration in which a printed circuit board of a wearable electronic device according to an embodiment of the disclosure includes a matching circuit.

Referring to FIG. 10, the wearable electronic device 200 may include a matching circuit 1010 disposed on a printed circuit board 340.

According to an embodiment, a Hall sensor 325 (e.g., a Hall IC) may be electrically connected to the printed circuit board 340 through a conductive connection member 320 (e.g., an FPCB).

According to an embodiment, the printed circuit board 340 may be electrically connected to the conductive connection member 320 through the matching circuit 1010. For example, the matching circuit 1010 may include a tunable switch (tunable IC). For example, the matching circuit 1010 may open or short the conductive connection member 320 and a ground G of the printed circuit board 340, or may shift resonance of a predetermined frequency band (e.g., a high-frequency band or a low-frequency band).

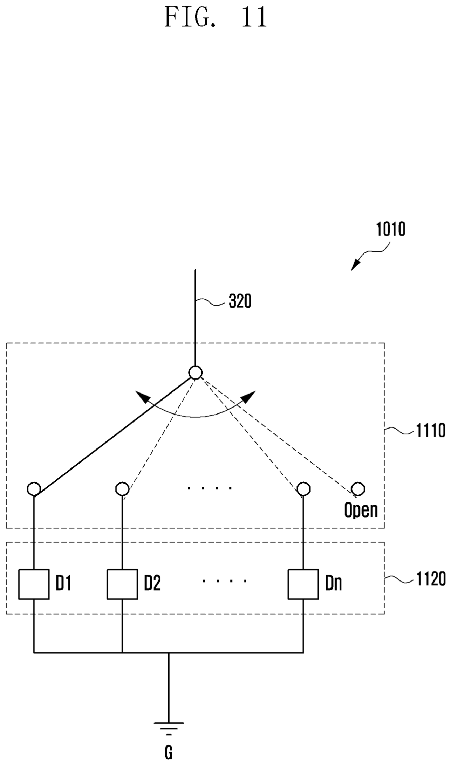

According to an embodiment, the matching circuit 1010 may include a capacitor (e.g., the capacitor D1 of FIG. 11) and/or an inductor (e.g., the inductor D2 of FIG. 11). For example, the matching circuit 1010 may shift antenna resonance to a lower-frequency band using a capacitance component of the capacitor and may shift antenna resonance to a higher-frequency band using an inductance component of the inductor.

FIG. 11 is a view schematically illustrating a configuration of a matching circuit of a wearable electronic device according to an embodiment of the disclosure.

Referring to FIG. 11, a matching circuit 1010 according to various embodiments of the disclosure may include at least one switch 1110, or one or more passive elements 1120 (e.g., a capacitor D1, an inductor D2, ..., Dn, or Open) that are electrically connected to a conductive connection member 320 or disconnect an electrical path from the conductive connection member 320 by the at least one switch 1110. The one or more passive elements 1120 may have different element values from each other. The one or more passive elements 1120 (e.g., lumped elements) may include a capacitor D1 having various capacitance values and/or an inductor D2 having various inductance values. The at least one switch 1110 may, for example, selectively connect an element having a predetermined element value (e.g., a matching value) to the conductive connection member 320 under control of a processor 120 illustrated in FIG. 1. In an embodiment, the at least one switch 1110 may include a micro-electro mechanical systems (MEMS) switch. The MEMS switch, which performs a mechanical switching operation using an internal metal plate and provides a complete turn-on/off characteristic, may not substantially affect changes in radiation characteristics of an antenna. In some embodiments, the at least one switch 1110 may include a single pole single throw (SPST) switch, a single pole double throw (SPDT) switch, or a switch including three or more throws (e.g., SP4T).

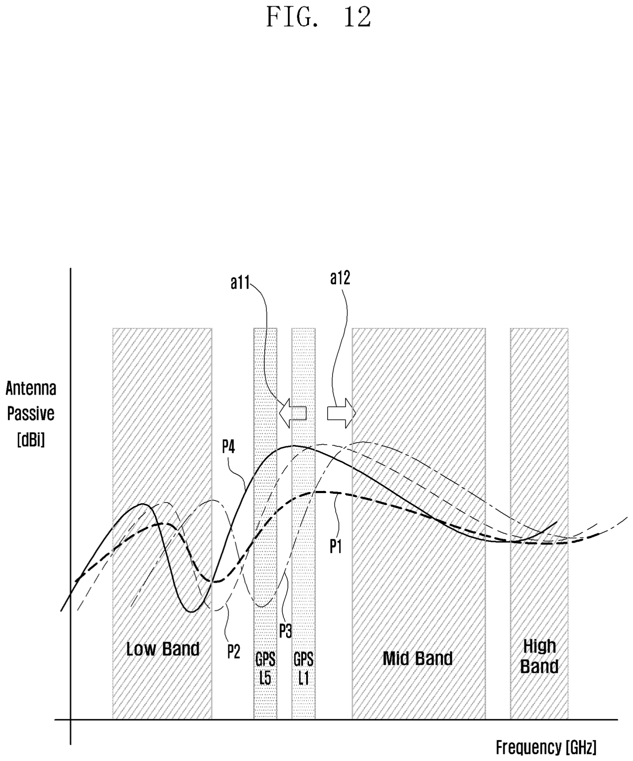

FIG. 12 is a view schematically illustrating a passive resonance shift of an antenna by using a matching circuit of a wearable electronic device according to an embodiment of the disclosure.

Referring to FIG. 12, a first graph P1 may represent a frequency resonance shift of a wearable electronic device according to a comparative embodiment. For example, a second graph P2 may represent a frequency resonance shift of a wearable electronic device 200 including a conductive connection member 320 according to an embodiment of the disclosure. For example, a third graph P3 may represent a frequency resonance shift by using an inductor D2 of a matching circuit 1010 according to an embodiment of the disclosure. For example, a fourth graph P4 may represent a frequency resonance shift by using a capacitor D1 of the matching circuit 1010 according to an embodiment of the disclosure.

According to an embodiment, the wearable electronic device 200 according to an embodiment of the disclosure may shift antenna resonance with respect to the GPS L1 and GPS L5 frequency bands toward a higher-frequency band, as indicated by the second arrow a12, by using an inductance component of the inductor D2 of the matching circuit 1010.

According to an embodiment, the wearable electronic device 200 according to an embodiment of the disclosure may shift antenna resonance with respect to the GPS L1 and GPS L5 frequency bands toward a lower-frequency band, as indicated by the first arrow a11, by using a capacitance component of the capacitor D1 of the matching circuit 1010.

A wearable electronic device 200 according to an embodiment of the disclosure may include a housing 210 including a conductive material, a support member 310 disposed inside the housing 210, a display 220 disposed on the support member 310, a printed circuit board 340 disposed on the support member 310, and a conductive connection member 320 including a first portion 321 arranged to be coupled to at least a portion of the housing 210, and a second portion 322 electrically connected to a ground G of the printed circuit board 340.

According to an embodiment, a spacing distance between the first portion 321 of the conductive connection member 320 and the housing 210 may range from about 0.3 mm to about 1.2 mm.

According to an embodiment, the conductive connection member 320 may include at least one Hall sensor 325.

According to an embodiment, the conductive connection member 320 may include a flexible printed circuit board (FPCB).

According to an embodiment, the first portion 321 of the conductive connection member 320 may include a first groove 321a and/or a second groove 321b.

According to an embodiment, the first portion 321 of the conductive connection member 320 may include a first area 710.

According to an embodiment, the first area 710 may be a reduced area in which a periphery of the second groove 321b is removed.

According to an embodiment, the first portion 321 of the conductive connection member 320 may include a second area 820.

According to an embodiment, the second area 820 may be an expanded area in which a conductive material is filled in the first groove 321a.

According to an embodiment, the housing 210 may be configured to operate as an antenna supporting a frequency band ranging from about 1140 MHz to about 1580 MHz.

According to an embodiment, the printed circuit board 340 may be electrically connected to the conductive connection member 320 through a matching circuit 1010.

According to an embodiment, the matching circuit 1010 may include at least one switch 1110 and at least one passive element 1120.

According to an embodiment, the at least one passive element 1120 may include a capacitor D1 and an inductor D2.

According to an embodiment, the matching circuit 1010 may be configured to shift a frequency band to a lower-frequency band by using a capacitance component of the capacitor D1.

According to an embodiment, the matching circuit 1010 may be configured to shift a frequency band to a higher-frequency band by using an inductance component of the inductor D2.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively," as "coupled with," "coupled to," "connected with," or "connected to" another element (e.g., a second element), it denotes that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

In the foregoing, the disclosure has been described with reference to various embodiments of the disclosure, but it is evident that changes and modifications made by a person ordinarily skilled in the art to which the disclosure belongs without departing from the technical spirit of the disclosure fall within the scope of the disclosure.

## Claims

1. A wearable electronic device (200) comprising:
a housing (210) including a conductive material;
a support member (310) disposed inside the housing (210);
a display (220) disposed on the support member (310);
a printed circuit board (340) disposed on the support member (310); and
a conductive connection member (320) including a first portion (321) arranged to be coupled to at least a portion of the housing (210), and a second portion (322) electrically connected to a ground (G) of the printed circuit board (340).

2. The wearable electronic device of claim 1, wherein a spacing distance between the first portion (321) of the conductive connection member (320) and the housing (210) ranges from about 0.3 mm to about 1.2 mm.

3. The wearable electronic device of claim 1 or 2, wherein the conductive connection member (320) comprises at least one Hall sensor (325).

4. The wearable electronic device of any one of claims 1 to 3, wherein the conductive connection member (320) comprises a flexible printed circuit board (FPCB).

5. The wearable electronic device of any one of claims 1 to 4, wherein the first portion (321) of the conductive connection member (320) comprises a first groove (321a) and/or a second groove (321b).

6. The wearable electronic device of claim 5, wherein the first portion (321) of the conductive connection member (320) comprises a first area (710).

7. The wearable electronic device of claim 6, wherein the first area (710) is a reduced area in which an area around the second groove (321b) is removed.

8. The wearable electronic device of claim 5, wherein the first portion (321) of the conductive connection member (320) comprises a second area (820).

9. The wearable electronic device of claim 8, wherein the second area (820) is an expanded area in which a conductive material is filled in the first groove (321a).

10. The wearable electronic device of any one of claims 1 to 9, wherein the housing (210) is configured to operate as an antenna supporting a frequency band ranging from about 1140 MHz to about 1580 MHz.

11. The wearable electronic device of any one of claims 1 to 10, wherein the printed circuit board (340) is electrically connected to the conductive connection member (320) through a matching circuit (1010).

12. The wearable electronic device of claim 11, wherein the matching circuit (1010) comprises at least one switch (1110) and at least one passive element (1120).

13. The wearable electronic device of claim 12, wherein the at least one passive element (1120) comprises a capacitor (D1) and an inductor (D2).

14. The wearable electronic device of claim 13, wherein the matching circuit (1010) is configured to shift a frequency band to a lower-frequency band by using a capacitance component of the capacitor (D1).

15. The wearable electronic device of claim 13, wherein the matching circuit (1010) is configured to shift a frequency band to a higher-frequency band by using an inductance component of the inductor (D2).
